(19) Europäisches Patentamt / European Patent Office / Office européen des brevets

(11) **EP 3 977 487 B1**

(12) **EUROPEAN PATENT SPECIFICATION**

(45) Date of publication and mention
of the grant of the patent:
**24.05.2023 Bulletin 2023/21**

(21) Application number: **20757425.2**

(22) Date of filing: **29.05.2020**

(51) International Patent Classification (IPC):
**G21C 17/104** $^{(2006.01)}$    **G21D 3/00** $^{(2006.01)}$
**G21C 17/108** $^{(2006.01)}$

(52) Cooperative Patent Classification (CPC):
**G21C 17/104; G21D 3/001;** G21C 17/108

(86) International application number:
**PCT/US2020/035090**

(87) International publication number:
**WO 2020/243408 (03.12.2020 Gazette 2020/49)**

(54) **SYSTEM AND METHOD TO DETERMINE REACTIVITY**

SYSTEM UND VERFAHREN ZUR BESTIMMUNG DER REAKTIVITÄT

SYSTÈME ET PROCÉDÉ POUR DÉTERMINER UNE RÉACTIVITÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.05.2019 US 201962854453 P**

(43) Date of publication of application:
**06.04.2022 Bulletin 2022/14**

(73) Proprietor: **Westinghouse Electric Company LLC
Cranberry Township, PA 16066 (US)**

(72) Inventors:
• **PRIBLE, Michael C.
Cranberry Township, PA 16066 (US)**
• **NEDWIDEK, Frank M.
Pittsburgh, PA 15202 (US)**
• **CHELEDNIK, Craig A.
Sewickley, PA 15143 (US)**

(74) Representative: **Fleuchaus & Gallo Partnerschaft
mbB
Steinerstraße 15/A
81369 München (DE)**

(56) References cited:
**JP-A- 2015 148 524      US-A- 4 938 917
US-A1- 2013 028 364**

• **DAS ET AL: "The importance of delayed neutrons
in nuclear research-A review", PROGRESS IN
NUCLEAR ENERGY, PERGAMON PRESS,
OXFORD, GB, vol. 28, no. 3, 1 January 1994
(1994-01-01), pages 209-264, XP023636349, ISSN:
0149-1970, DOI: 10.1016/0149-1970(94)90001-9
[retrieved on 1994-01-01]**

## Description

### FIELD

The disclosed concept pertains generally to nuclear reactors and, more particularly, to determining reactivity in a low power physics testing range of a nuclear reactor.

### BACKGROUND

Bank worth measurement of control rods and shut-down rods is required for every cycle startup of a nuclear power plant. For Pressurized Water Reactors (PWR), the bank worth measurement is part of the Low Power Physics Tests (LPPT) program. In almost all instances, this program is on critical path during ascension to power. There is a strong incentive for the utility industry to have a fast and reliable method of measuring the bank worth of control rods.

Various methods of measuring the bank worth of control rods have been developed. One method is a speedy rod insertion method for rod worth measurement on commercial PWR where spatial effect corrections are made to the detector signals using core design static calculation data. Another method is the Dynamic Rod Worth Measurement (DRWM™) method, which uses rigorous three-dimensional space-time kinetics core modeling, and has evolved to a matured technology that has been successfully applied to many PWR startups.

Two traditional bank worth measurement methods for PWRs are the boron dilution method and the rod swap method. In the boron dilution method, a bank of control rods is slowly inserted. After every rod stepping movement, the rod position is held while boron is diluted to compensate for the reactivity loss. Every rod position has to be held long enough to avoid space-time effect in order to validate the point core model used in the reactivity computer. The boron dilution method is therefore a very slow process. The rod swap method is considerably faster than the boron dilution method. In the rod swap method, the heaviest (highest worth) bank (called the reference bank) is first measured with the boron dilution method. The reference bank is then partially withdrawn while another test bank is being inserted. Using the partial worth of the reference bank to compensate for the worth of the test bank effectively determines the worth of the test bank. A typical LPPT using rod swap takes about 24 hours. The DRWM technique is a much faster method to quickly validate the predicted bank worths. It measures each bank separately and independently, driving each bank at its maximum allowable speed. The analysis method is based on three dimensional space-time kinetics theory, and the measurement data is processed with an Advanced Digital Reactivity Computer (ADRC).

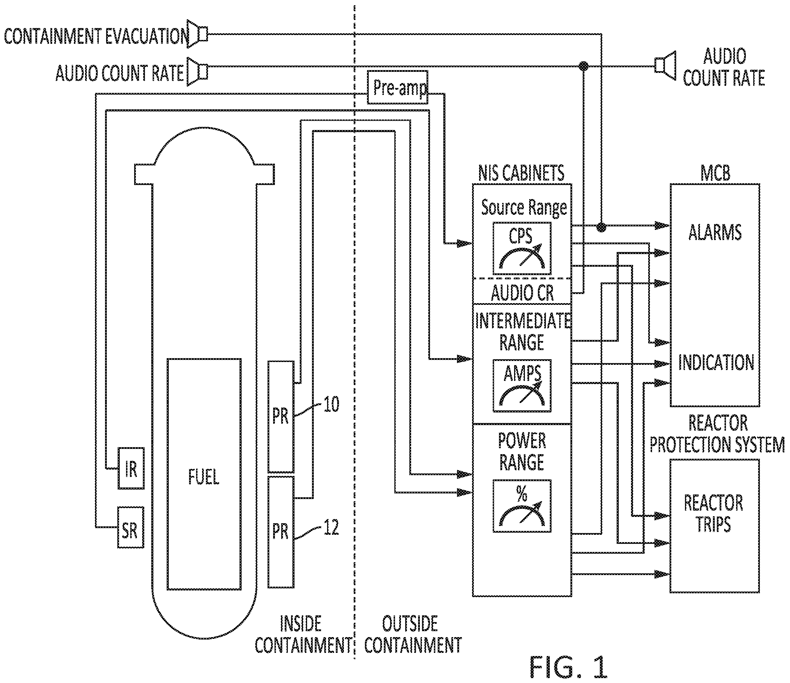

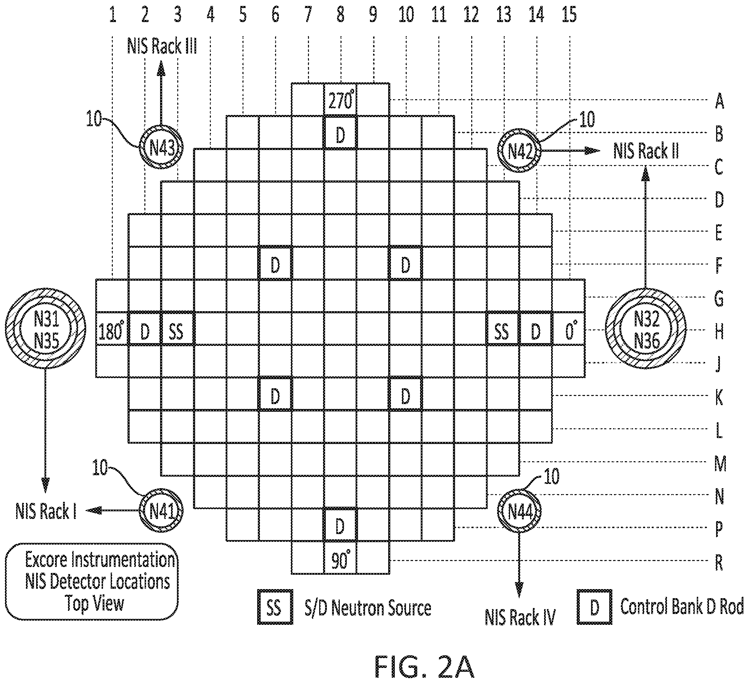

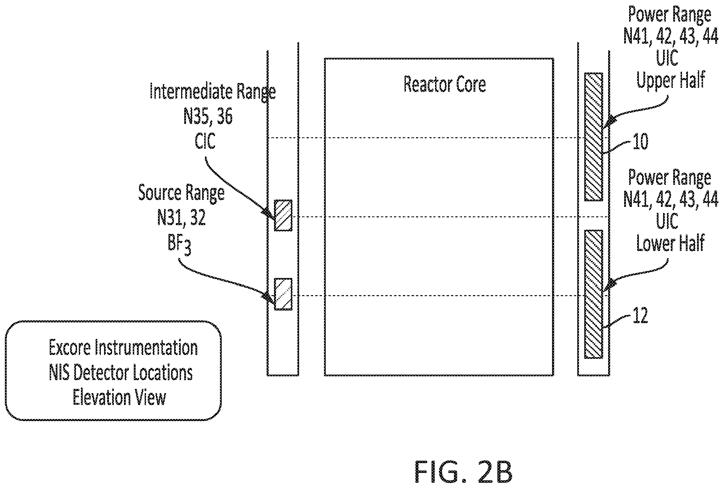

FIG. 1 is a simplified schematic diagram of a nuclear plant, FIG. 2A is a schematic top view of a reactor core and associated detectors, and FIG. 2B is a schematic side view of a reactor core and associated detectors. The DRWM methodology uses the uncompensated ion chamber power range detectors 10,12. The power range detectors 10,12 provide a broad view of one core quadrant and the upper power range detectors 10 and the lower power range detectors 12 are each approximately 5 feet long. Some plant designs utilize more than 2 segmented detectors, such as 6 or more segments but still provide ~10-12' of total effective detector length. This gives a broad axial core response for a typical 12-14' reactor core. Using the power range detectors 10,12 for DRWM typically requires removing one of the detector channels from service, which makes it unable to perform its safety function. Using the power range detectors 10,12 also involves accurately measuring picoampere level current signals, which requires several specialized, laboratory grade instruments, which are expensive and bulky.

The ADRC requires input from one power range detector, which renders the corresponding nuclear instrumentation channel out of service. This could be unfavorable from the station perspective if the unit is not capable of functionally bypassing a power range channel because the plant is closer to a trip condition during physics testing (i.e. 1/3 trip logic when one power range is out of service as compared to 2/4 trip logic when all power range channels are operable).

In another method, an Intermediate Range Digital Reactivity Computer (IRDRC) utilizes intermediate range detector signals. The IRDRC reduces the plant impact of taking a power range channel out of service to perform LPPT. However, the IRDRC has historically only been used to perform the traditional reactivity computer measurements such as boron endpoint (BEP) measurement, isothermal temperature coefficient (ITC) measurement, bank worth measurement by dilution/boration, and rod swap.

The Nuclear Instrumentation System (NIS) is a safety related system which typically utilizes 3 detector types (commonly Source, Intermediate and Power Range, as shown in FIG. 1) to provide adequate monitoring over numerous decades of reactor power. Each NIS can be used as an input to a reactivity computer to calculate various core design parameters, as is done, for example, in U.S. Patent No. 4,877,575. The intermediate and power range detector signals represent a directly proportional value to neutron flux and used to solve the Inverse Point Kinetics Equation or other reactivity equations. A reactivity computer can connect directly to a detector; however it is then unable to perform its safety related function. So it is desirable to use isolated outputs when possible so the detector can retain its safety related function. Isolated outputs are typically a 0-5V or 0-10V output based on the range of detector current or pulses. For example, outputs of an exemplary compensated ion chamber intermediate range detector ranges from $10^{-11}$ to $10^{-3}$ amperes and its associated processing cabinet produces a 0-5V or 0-10V output.

Fission chamber detectors, such as those described in U.S. Patent No. 4,495,144, using enriched U-235 are also commonly used as incore and excore nuclear instrumentation systems to monitor reactor power. This detector type can have several modes of operation; (1) pulse mode in which neutron pulses are detected and recorded; (2) mean-square-voltage (MSV) mode in which a pre-amplifier is used to amplify the pulse signals and provide a signal proportional to the square root of reactor power.

It is difficult to align the transition point between the two modes of operation. At the transition point between the two modes of operation, the detector signal output undergoes a step change. One prior method attempted to correct this issue with the signal processing techniques using rate of change circuits to reduce the impact of the transient. Although this particular detector design, and others, do reduce the transient from older detector systems, the transient is still large enough to have a noticeable impact on calculated reactivity when using the detector output because the signal has a jump transition that is not proportional to reactor power. The prior method was also solely focused on the detector and signal processing electronics and not the ability or inability to calculate reactivity. This transition issue and the subsequent impact on calculated reactivity makes it unusable for use in low power physics testing if left uncorrected.

U.S. Patent No. 4,877,575 uses two or more neutron detectors and statistically compares their outputs to perform a validation of calculated reactivity. However, this method requires the use of two or more neutron detectors to validate the calculated reactivity.

Further relevant prior art is known from: DAS ET AL: "The importance of delayed neutrons in nuclear research-A review", PROGRESS IN NUCLEAR ENERGY, PERGAMON PRESS, OXFORD, GB, vol. 28, no. 3, 1 January 1994 (1994-01-01), pages 209-264, ISSN: 0149-1970, DOI: 10.1016/0149-1970(94)90001-9 .

There is room for improvement in calculating reactivity in the low power physics testing range of a nuclear reactor.

SUMMARY

Aspects of the disclosed concept provide improved reactivity calculations through the low power physics testing range of a nuclear reactor.

As one aspect of the disclosed concept, a method of determining reactivity of a nuclear reactor comprises: receiving a neutron detector response for a discrete period of time; performing a statistical check on the neutron detector response; determining when the neutron detector response is acceptable based on the statistical check; and calculating reactivity using a prior delayed neutron concentration when the neutron detector response is not acceptable and using a newly calculated delayed neutron concentration when the neutron detector response is acceptable.

As another aspect of the disclosed concept, a system for calculating reactivity of a reactor core comprises: a neutron detector structured to detect neutron flux produced in the reactor core; and a reactivity computer structured to receive a neutron detector response based on an output of the neutron detector, the reactivity computer including a processor and a memory, the memory including a reactivity calculation routine and the processor being structured to execute the reactivity calculation routine. The reactivity routine comprises: receiving the neutron detector response for a discrete period of time; performing a statistical check on the neutron detector response; determining when the neutron detector response is acceptable based on the statistical check; and calculating reactivity using a prior delayed neutron concentration when the neutron detector response is not acceptable and using a newly calculated delayed neutron concentration when the neutron detector response is acceptable.

BRIEF DESCRIPTION OF THE DRAWINGS

A further understanding of the invention can be gained from the following description of the preferred aspects when read in conjunction with the accompanying drawings in which:

FIG. 1 is a simplified schematic diagram of a nuclear plant;
FIG. 2A is a schematic top view of a reactor core and associated detectors;
FIG. 2B is a schematic side view of a reactor core and associated detectors;
FIG. 3 is a flowchart of a method of determining reactivity in accordance with an example aspect of the disclosed concept;
FIG. 4 is a chart of a neutron detector signal output and reactivity calculations in accordance with an example aspect of the disclosed concept; and
FIG. 5 is a simplified schematic diagram of a system for calculating reactivity in accordance with an example aspect of the disclosed concept.

DETAILED DESCRIPTION

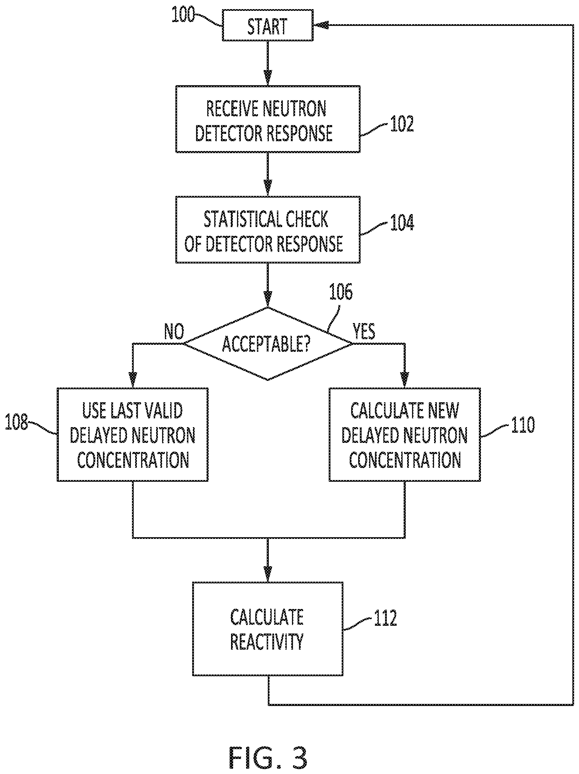

FIG. 3 is a flowchart of a method of determining reactivity in accordance with an example aspect of the disclosed concept. The method eliminates the impact of a step change in detector current when the detector transitions between modes of operation and the output signal is not proportional to reactor power.

The method begins at 100 and proceeds to 102. At 102, a neutron detector response is received by the reactivity computer. The neutron detector response is received by the reactivity computer over a discrete amount of time such as one second. However, it will be appreciated that any suitable discrete amount of time may be used without departing from the scope of the disclosed concept. In some example aspects of the disclosed concept, the neutron detector may be a fission chamber detector such as that described in U.S. Patent No. 4,495,144. In some example aspects of the disclosed concept, the neutron detector has two modes of operation: (1) a pulse mode in which neutron pulses are detected and recorded; and (2) a mean-square voltage mode in which a pre-amplifier is used to amplify the pulse signals and provide a signal proportional to the square root of reactor power.

The method continues at 104 where a statistical check of the neutron detector response is performed by the reactivity computer. In some example aspects of the disclosed concept, the statistical check looks for a jump in the neutron detector response. For example, the statistical check may check whether the neutron detector response changes by a predetermined number of standard deviations (e.g., without limitation, two standard deviations) across the discrete time period in which the neutron detector response was received. However, it will be appreciated that other statistical methods may be used to determine whether the neutron detector response changes by more than a predetermined amount across the discrete time period without departing from the scope of the disclosed concept.

At 106, the reactivity computer may determine whether the neutron detector response is acceptable. For example, based on the statistic check performed in 104 by the reactivity computer, if the neutron detector response changes by the predetermined number of standard deviations or otherwise changes by more than a predetermined amount, it is determined that the neutron detector response is not acceptable. Such a change is indicative of the neutron detector switching modes and causing a step in its output. If the neutron detector response does not change by the predetermined number of standard deviations or otherwise does not change by more than a predetermined amount, it is determined that the neutron detector response is acceptable.

If the neutron detector response is determined by the reactivity computer not to be acceptable, the method proceeds to 108 and if the neutron detector response is determined by the reactivity computer to be acceptable, the method proceeds to 110. At 108, the last valid delayed neutron concentration is used in the reactivity calculation. The last valid delayed neutron concentration may be obtained from a previous iteration of the method. For example, if the method runs each discrete time period of one second, the delayed neutron concentration from the previous one second time period may be used if the neutron detector response for that discrete time period was acceptable. At 110, a new delayed neutron concentration is calculated by the reactivity computer. This delayed neutron concentration is considered valid and may be used in a subsequent iteration of the method.

At 112, reactivity is calculated by the reactivity computer. The reactivity is calculated by the reactivity computer using the last valid delayed neutron concentration if the neutron detector response was not acceptable or using the newly calculated delayed neutron concentration if the neutron detector response was acceptable. In some example aspects, reactivity is calculated by the reactivity computer using an inverse point kinetics equation. An inverse point kinetics equation in accordance with an example aspect of the disclosed concept is provided below.

$$\rho(t) = \beta - \frac{1}{T(t)} \sum_i \lambda_i C_i(t)$$

$$\frac{dC_i(t)}{dt} = \beta_i T(t) - \lambda_i C_i(t)$$

Where:

$$\widehat{C}_i = \Lambda C_i$$

$$T(t) = \mu DR(t)$$

In the inverse point kinetics equation: $C_i(t)$ is the delayed neutron concentrations of group i; $\Lambda$ is the prompt generation time; $\rho$ is the reactivity; the constants $\beta_i$ and $\lambda_i$ are the fraction and decay constant of delayed neutron precursor of group i; DR is the magnitude of the detector response signal; and $\mu$ is the prompt neutron lifetime.

The change in neutron detector modes causes a step transition in the neutron detector response which can artificially skew the anticipated neutron population and delayed neutron concentrations in the inverse point kinetics equation. By using the last valid delayed neutron concentration during the step transition, the reactivity computer may eliminate the effect of the step transition on the reactivity calculation. Thus, using the method described above, reactivity can be accurately calculated by the reactivity computer through the change in modes of the neutron detector.

Once reactivity is calculated at 112, the method returns to 100. The method continually repeats each discrete time period.

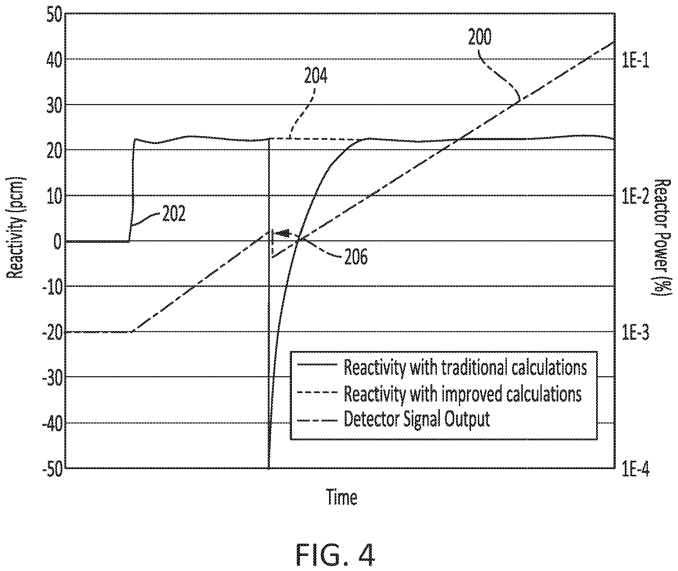

For example, FIG. 4 is a chart of a neutron detector signal output and reactivity calculations in accordance with an example aspect of the disclosed concept. As shown in FIG. 4, the neutron detector output signal 200 generally has a constant upward slope during a positive reactivity addition (i.e., when reactor power is increasing). Conversely, the neutron detector output signal 200 would generally have a constant downward slope when reactor power is decreasing. However, a change in modes of the neutron detector causes a step transition 206. This step transition 206 causes a spike in calculated reactivity using traditional reactivity calculations 202.

However, the calculated reactivity using improved calculations 204 eliminates the spike and allows accurate calculation of reactivity through the change in modes of the neutron detector. The improved calculations are those using the method described in connection with FIG. 3. The change in modes of the neutron detector typically occurs during the low power physics testing range and, thus, traditional reactivity calculations cannot be used for low power physics testing, while the improved reactivity calculation can be used to accurately calculate reactivity during low power physics testing of a nuclear reactor. Additionally, the improved reactivity calculation only uses the output signal from one neutron detector rather than multiple neutron detectors.

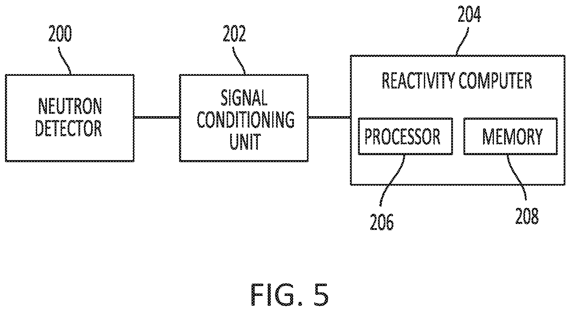

FIG. 5 is a simplified schematic diagram of a system for calculating reactivity in accordance with an example aspect of the disclosed concept. The system may implement the method described in connection with FIG. 3. The system includes a neutron detector 200, such as a fission chamber detector, a signal conditioning unit 202, and a reactivity computer 204. The neutron detector 200 detects neutron flux produced in a reactor core and produces electrical current signals proportional to the flux detected. The signal conditioning unit 202 processes the output of the neutron detector 202 processes the output of the neutron detector 200 so that it is suitable for use by the reactivity computer 204.

The reactivity computer 204 includes a processor 206 and associated memory 208. The memory 208 is structured to store one or more routines and the processor 206 is structured to execute the one or more routines. In some example aspects of the disclosed concept, the memory 208 stores an improved reactivity calculation routine. The improved reactivity calculation routine may be the method described in connection with FIG. 3, which is executed by the processor 206. Thus, the reactivity computer 204 is able to implement the improved reactivity calculation described in connection with FIG. 3.

As described herein, example aspects of the disclosed concept provide systems and methods of accurately calculating reactivity through a change in modes of a neutron detector while using the output of just one neutron detector. Example aspects of the disclosed concept are suitable for calculating reactivity in the low power physics testing range of a nuclear reactor.

While specific aspects of the invention have been described in detail, it will be appreciated by those skilled in the art that various modifications and alternatives to those details could be developed in light of the overall teachings of the disclosure and that selected elements of one or more of the example aspects may be combined with one or more elements from other aspects without varying from the scope of the disclosed concepts. Accordingly, the particular aspects disclosed are meant to be illustrative only and not limiting as to the scope of the invention which is given by the appended claims.

**Claims**

1. A method of determining reactivity of a nuclear reactor, the method comprising:

    receiving, by a reactivity computer comprising a processor and a memory, a neutron detector response for a discrete period of time;
    **characterized by**
    performing, by the reactivity computer, a statistical check on the neutron detector response;
    determining, by the reactivity computer, when the neutron detector response is acceptable based on the statistical check; and
    calculating, by the reactivity computer, a reactivity using a prior delayed neutron concentration when the neutron detector response is not acceptable and using a newly calculated delayed neutron concentration when the neutron detector response is acceptable.

2. The method of claim 1, wherein performing the statistical check comprises determining, by the reactivity computer, when the neutron detector response changes by a predetermined number of standard deviations during the discrete time period, and wherein determining, by the reactivity computer, when the neutron detector response is acceptable comprises determining, by the reactivity computer, that the neutron detector response is acceptable when the neutron detector response changes by less than the predetermined number of standard deviations during the discrete time period and determining that the neutron detector response is not acceptable when the neutron detector response changes by the predetermined number of standard deviations or more during the discrete time period.

3. The method of claim 1, wherein performing, by the reactivity computer, the statistical check comprises determining, by the reactivity computer, when the neutron detector response changes by a predetermined amount during the discrete time period, and wherein determining, by the reactivity computer, when the neutron detector response is acceptable comprises determining that the neutron detector response is acceptable when the neutron detector response changes by less than the predetermined amount during the discrete time period and determining, by the reactivity computer, that the neutron detector response is not acceptable when the neutron detector response changes by the predetermined amount or more during the discrete time period.

4. The method of claim 1, wherein receiving, by a reactivity computer comprising a processor and a memory, a neutron detector response comprises receiving, by the reactivity computer, a response from the neutron detector operating in a first mode or operating in a second mode.

5. The method of claim 4, wherein receiving, by a reactivity computer, a response from the neutron detector operating in a first mode comprises receiving, by a reactivity computer, a response from the neutron detector operating in a pulse mode wherein a plurality of neutron pulses is detected and recorded, and
wherein receiving, by a reactivity computer, a response from the neutron detector operating in a second mode comprises receiving, by a reactivity computer, a response from the neutron detector operating in a mean-square voltage mode wherein a preamplifier is configured to amplify a plurality of pulse signals and provide a signal proportional to a square root of a reactor power.

6. The method of claim 1, wherein calculating reactivity, by the reactivity computer, comprises calculating, by the reactivity computer, an inverse point kinetics equation to calculate reactivity.

7. A system for calculating reactivity of a reactor core, the system comprising:

a neutron detector (200) configured to detect neutron flux produced in the reactor core; and a reactivity computer (204) configured to receive a neutron detector response based on an output of the neutron detector, the reactivity computer comprising a processor (206) and a memory (208), the memory configured to store a reactivity calculation routine and the processor being configured to execute the reactivity calculation routine, the reactivity routine comprising:
receiving, by the reactivity computer, the neutron detector response for a discrete period of time;
**characterized in that** the reactivity routine also comprises:

performing, by the reactivity computer, a statistical check on the neutron detector response;
determining, by the reactivity computer, when the neutron detector response is acceptable based on the statistical check; and

calculating, by the reactivity computer, a reactivity using a prior delayed neutron concentration when the neutron detector response is not acceptable and using a newly calculated delayed neutron concentration when the neutron detector response is acceptable.

**Patentansprüche**

1. Verfahren zur Ermittlung der Reaktivität eines Kernreaktors, wobei das Verfahren Folgendes umfasst:

Empfangen einer Neutronendetektorantwort für eine diskrete Zeitperiode durch einen Reaktivitätsrechner, der einen Prozessor und einen Speicher umfasst;
**gekennzeichnet durch**
Durchführung einer statistischen Prüfung der Neutronendetektorantwort durch den Reaktivitätsrechner;
Ermittlung dessen, wann die Neutronendetektorantwort auf Basis der statistischen Prüfung akzeptabel ist, durch den Reaktivitätsrechner; und
Berechnung einer Reaktivität durch den Reaktivitätsrechner unter Verwendung einer früheren verzögerten Neutronenkonzentration, wenn die Neutronendetektorantwort nicht akzeptabel ist, und unter Verwendung einer neu berechneten verzögerten Neutronenkonzentration, wenn die Neutronendetektorantwort akzeptabel ist.

2. Verfahren nach Anspruch 1, wobei die Durchführung der statistischen Prüfung die Ermittlung dessen durch den Reaktivitätsrechner umfasst, wann sich die Neutronendetektorantwort um eine vorbestimmte Anzahl von Standardabweichungen während der diskreten Zeitperiode ändert, und
wobei die Ermittlung dessen durch den Reaktivitätsrechner, wann die Neutronendetektorantwort akzeptabel ist, die Ermittlung dessen durch den Reaktivitätsrechner, dass die Neutronendetektorantwort akzeptabel ist, wenn sich die Neutronendetektorantwort um weniger als die vorbestimmte Anzahl von Standardabweichungen während der diskreten Zeitperiode ändert, und die Ermittlung dessen umfasst, dass die Neutronendetektorantwort nicht akzeptabel ist, wenn sich die Neutronendetektorantwort um die vorbestimmte Anzahl von Standardabweichungen oder mehr während der diskreten Zeitperiode ändert.

3. Verfahren nach Anspruch 1, wobei die Durchführung der statistischen Prüfung durch den Reaktivitätsrechner die Ermittlung dessen durch den Reaktivitätsrechner umfasst, wann sich die Neutronendetektorantwort um einen vorbestimmten Betrag während der diskreten Zeitperiode ändert, und
wobei die Ermittlung dessen durch den Reaktivitätsrechner, wann die Neutronendetektorantwort akzeptabel ist, die Ermittlung dessen, dass die Neutronendetektorantwort akzeptabel ist, wenn sich die Neutronendetektorantwort um weniger als den vorbestimmten Betrag während der diskreten Zeitperiode ändert, und die Ermittlung dessen, dass die Neutronendetektorantwort nicht akzeptabel ist, wenn sich die Neutronendetektorantwort um den vorbestimmten Betrag oder mehr während der diskreten Zeitperiode ändert, durch den Reaktivitätsrechner umfasst.

4. Verfahren nach Anspruch 1, wobei das Empfangen einer Neutronendetektorantwort durch einen Reaktivitätsrechner, der einen Prozessor und einen Speicher umfasst, das Empfangen einer Antwort aus dem Neutronendetektor, der in einem ersten Modus oder in einem zweiten Modus arbeitet, durch den Reaktivitätsrechner umfasst.

5. Verfahren nach Anspruch 4, wobei das Empfangen einer Antwort aus dem Neutronendetektor, der in einem ersten Modus arbeitet, durch einen Reaktivitätsrechner das Empfangen einer Antwort aus dem Neutronendetektor, der in einem Impulsmodus arbeitet, in dem eine Mehrzahl von Neutronenimpulsen erfasst und aufgezeichnet wird, durch einen Reaktivitätsrechner umfasst, und wobei das Empfangen einer Antwort aus dem Neutronendetektor, der in einem zweiten Modus arbeitet, durch einen Reaktivitätsrechner das Empfangen einer Antwort aus dem Neutronendetektor, der in einem Modus mit mittlerer quadratischer Spannung arbeitet, durch einen Reaktivitätsrechner umfasst, wobei ein Vorverstärker so konfiguriert ist, dass er eine Mehrzahl von Impulssignalen verstärkt und ein zur Quadratwurzel einer Reaktorleistung proportionales Signal bereitstellt.

6. Verfahren nach Anspruch 1, wobei die Berechnung der Reaktivität durch den Reaktivitätsrechner die Berechnung einer inversen punktkinetischen Gleichung zur Berechnung der Reaktivität durch den Reaktivitätsrechner umfasst.

7. System zur Berechnung der Reaktivität eines Reaktorkerns, wobei das System Folgendes umfasst:

einen Neutronendetektor (200), der so konfiguriert ist, dass er den im Reaktorkern erzeugten Neutronenfluss erfasst; und einen Reaktivitätsrechner (204), der so konfiguriert ist, dass er eine Neutronendetektorantwort auf Basis einer Ausgabe des Neutronendetektors empfängt, wobei der Reaktivitätsrechner einen Prozessor (206) und einen Speicher (208) umfasst, wobei der Speicher zum Speichern einer Reaktivitätsberechnungsroutine konfiguriert ist und der Prozessor zum Ausführen der Reaktivitätsberechnungsroutine konfiguriert ist, wobei die Reaktivitätsroutine Folgendes umfasst:
Empfangen der Neutronendetektorantwort für eine diskrete Zeitperiode durch den Reaktivitätsrechner;

**dadurch gekennzeichnet, dass** die Reaktivitätsroutine außerdem umfasst:

Durchführung einer statistischen Prüfung der Neutronendetektorantwort durch den Reaktivitätsrechner;
Ermittlung dessen, wann die Neutronendetektorantwort auf Basis der statistischen Prüfung akzeptabel ist, durch den Reaktivitätsrechner; und
Berechnung einer Reaktivität durch den Reaktivitätsrechner unter Verwendung einer früheren verzögerten Neutronenkonzentration, wenn die Neutronendetektorantwort nicht akzeptabel ist, und unter Verwendung einer neu berechneten verzögerten Neutronenkonzentration, wenn die Neutronendetektorantwort akzeptabel ist.

## Revendications

1. Méthode de détermination de la réactivité d'un réacteur nucléaire, la méthode comprenant :

la réception, par un ordinateur de réactivité comprenant un processeur et une mémoire, d'une réponse du détecteur de neutrons pendant une période de temps discrète ;
**caractérisée par**
la réalisation, par l'ordinateur de réactivité, d'un contrôle statistique de la réponse du détecteur de neutrons ;
la détermination, par l'ordinateur de réactivité, du moment auquel la réponse du détecteur de neutrons est acceptable en se basant sur le contrôle statistique ; et
le calcul, par l'ordinateur de réactivité, d'une réactivité en utilisant une concentration de neutrons différée antérieure lorsque la réponse du détecteur de neutrons n'est pas acceptable et en utilisant une concentration de neutrons différée nouvellement calculée lorsque la réponse du détecteur de neutrons est acceptable.

2. Méthode selon la revendication 1, dans laquelle le contrôle statistique comprend la détermination, par l'ordinateur de réactivité, du moment auquel la réponse du détecteur de neutrons change d'un nombre prédéterminé de déviations standard pendant la période de temps discrète, et dans laquelle la détermination, par l'ordinateur de réactivité, du moment auquel la réponse du détecteur de neutrons est acceptable, comprend la détermination, par l'ordinateur de réactivité, que la réponse du détecteur de neutrons est acceptable lorsque la réponse du détecteur de neutrons change d'un nombre inférieur à celui prédéterminé de déviations standard pendant la période de temps discrète et la détermination que la réponse du détecteur de neutrons n'est pas acceptable lorsque la réponse du détecteur de neutrons change du nombre prédéterminé de déviations standard ou plus pendant la période de temps discrète.

3. Méthode selon la revendication 1, dans laquelle la réalisation, par l'ordinateur de réactivité, du contrôle statistique comprend la détermination, par l'ordinateur de réactivité, du moment auquel la réponse du détecteur de neutrons change d'une valeur prédéterminée pendant la période de temps discrète, et dans laquelle la détermination, par l'ordinateur de réactivité, du moment auquel la réponse du détecteur de neutrons est acceptable, comprend la détermination que la réponse du détecteur de neutrons est acceptable lorsque la réponse du détecteur de neutrons change d'une valeur inférieure à celle prédéterminée pendant la période de temps discrète et la détermination, par l'ordinateur de réactivité, que la réponse du détecteur de neutrons n'est pas acceptable lorsque la réponse du détecteur de neutrons change de la valeur prédéterminée ou plus pendant la période de temps discrète.

4. Méthode selon la revendication 1, dans laquelle la réception, par un ordinateur de réactivité comprenant un processeur et une mémoire, d'une réponse du détecteur de neutrons comprend la réception, par l'ordinateur de réactivité, d'une réponse issue du détecteur de neutrons fonctionnant dans un premier mode ou fonctionnant dans un second mode.

5. Méthode selon la revendication 4, dans laquelle la réception, par un ordinateur de réactivité, d'une réponse issue du détecteur de neutrons fonctionnant dans un premier mode, comprend la réception, par un ordinateur de réactivité, d'une réponse issue du détecteur de neutrons fonctionnant dans un mode d'impulsion, dans laquelle une pluralité d'impulsions de neutrons est détectée et enregistrée, et dans laquelle la réception, par un ordinateur de réactivité, d'une réponse issue du détecteur de neutrons fonctionnant dans un second mode, comprend la réception, par un ordinateur de réactivité, d'une réponse issue du détecteur de neutrons fonctionnant dans un mode de tension quadratique moyenne, dans laquelle un préamplificateur est configuré afin d'amplifier une pluralité de signaux d'impulsions et de livrer un signal proportionnel à une racine carrée d'une puissance de réacteur.

6. Méthode selon la revendication 1, dans laquelle le calcul de réactivité, par l'ordinateur de réactivité, comprend le calcul, par l'ordinateur de réactivité, d'une équation cinétique à point inverse afin de calculer la réactivité.

7. Système en vue de calculer la réactivé d'un coeur de réacteur, le système comprenant :

    un détecteur de neutron (200) configuré afin de détecter un flux de neutrons produit dans le cœur du réacteur; et
    un ordinateur de réactivité (204) configuré afin de recevoir une réponse du détecteur de neutron en se basant sur une émission du détecteur de neutron, l'ordinateur de réactivité comprenant un processeur (206) et une mémoire (208), la mémoire étant configurée afin de stocker une routine de calcul de réactivité et le processeur étant configuré afin d'exécuter la routine de calcul de réactivité, la routine de réactivité comprenant :
    la réception, par l'ordinateur de réactivité, de la réponse du détecteur de neutrons pendant une période de temps discrète ;
    **caractérisé en ce que** la routine de réactivité comprend également :

        la réalisation, par l'ordinateur de réactivité, d'un contrôle statistique de la réponse du détecteur de neutrons ;
        la détermination, par l'ordinateur de réactivité, du moment auquel la réponse du détecteur de neutrons est acceptable en se basant sur le contrôle statistique ; et
        le calcul, par l'ordinateur de réactivité, d'une réactivité en utilisant une concentration de neutrons différée antérieure lorsque la réponse du détecteur de neutrons n'est pas acceptable et en utilisant une concentration de neutrons différée nouvellement calculée lorsque la réponse du détecteur de neutrons est acceptable.

FIG. 1

FIG. 2A

Intermediate Range
N35, 36
CIC

Source Range
N31, 32
$BF_3$

Reactor Core

Power Range
N41, 42, 43, 44
UIC
Upper Half

10

Power Range
N41, 42, 43, 44
UIC
Lower Half

12

Excore Instrumentation
NIS Detector Locations
Elevation View

FIG. 2B

FIG. 3

FIG. 4

EP 3 977 487 B1

**FIG. 5**

EP 3 977 487 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4877575 A

- US 4495144 A

**Non-patent literature cited in the description**

- The importance of delayed neutrons in nuclear research-A review. **DAS et al.** PROGRESS IN NUCLEAR ENERGY. PERGAMON PRESS, 01 January 1994, vol. 28, 209-264